# EUROPÄISCHE PATENTSCHRIFT

(11) **EP 3 782 288 B1**
(45) Veröffentlichungstag und Bekanntmachung des Hinweises auf die Patenterteilung: **23.03.2022**
(21) Anmeldenummer: 19729669.2
(22) Anmeldetag: 31.05.2019
(51) Int. Cl.: H03M 13/00, H04L 1/00

(54) **VERFAHREN UND SYSTEM ZUM FEHLERKORRIGIERENDEN ÜBERTRAGEN EINES DATENSATZES ÜBER EINE UNIDIREKTIONALE KOMMUNIKATIONSEINHEIT**
METHOD AND SYSTEM FOR FAULT-CORRECTING TRANSFER OF A DATASET VIA A UNIDIRECTIONAL COMMUNICATION UNIT
PROCÉDÉ ET SYSTÈME DE TRANSMISSION AVEC CORRECTION D'ERREURS D'UN ENSEMBLE DE DONNÉES SUR UNE UNITÉ DE COMMUNICATION UNIDIRECTIONNELLE

(30) Priorität: 06.06.2018 DE 102018208962
(43) Veröffentlichungstag der Anmeldung: 24.02.2021
(73) Patentinhaber: Siemens Mobility GmbH, 81739 München (DE)
(72) Erfinder: GASIBA, Tiago, 81549 München (DE); SEIFERT, Matthias, 21244 Buchholz (DE); WIMMER, Martin, 85579 Neubiberg (DE)
(86) Internationale Anmeldenummer: PCT/EP2019/064208
(87) Internationale Veröffentlichungsnummer: WO 2019/233897

(56) Entgegenhaltungen:
- DE-A1-102015 200 279
- US-A1- 2018 109 356
- WATSON NETFLIX M ET AL: "Forward Error Correction (FEC) Framework; rfc6363.txt", FORWARD ERROR CORRECTION (FEC) FRAMEWORK; RFC6363.TXT, INTERNET ENGINEERING TASK FORCE, IETF; STANDARD, INTERNET SOCIETY (ISOC) 4, RUE DES FALAISES CH- 1205 GENEVA, SWITZERLAND, 15. Oktober 2011 (2011-10-15), Seiten 1-42, XP015081311, [gefunden am 2011-10-15]
- Austin Scott: "Interested in learning more about cyber security training? Tactical Data Diodes in Industrial Automation and Control Systems", , 18. Mai 2015 (2015-05-18), XP055550479, Gefunden im Internet: URL:https://www.sans.org/reading-room/whit epapers/firewalls/tactical-data-diodes-ind ustrial-automation-control-systems-36057 [gefunden am 2019-02-01]

## Beschreibung

Die Erfindung betrifft ein Verfahren und ein System zum fehlerkorrigierenden Übertragen eines Datensatzes von einem ersten Netzwerk, wie z.B. ein sicherheitskritisches Industrienetzwerk, in ein zweites Netzwerk, wie z.B. ein Diagnosenetzwerk oder Büronetz, über eine unidirektionale Kommunikationseinheit, wobei ein Empfangsgerät im zweiten Netzwerk insbesondere lediglich eine beschränkte Rechen- und Hauptspeicherkapazität aufweist.

Industrielle Daten- und Kommunikationsnetze können aufgrund von Sicherheitsbestimmungen insbesondere als isolierte Netze realisiert sein, d.h. es ist in der Regel kein Datentransfer in das Netz hinein erlaubt und/oder möglich. Außerdem sind sicherheitskritische Netze oft nicht mit offenen Netzen, wie z.B. mit Büronetzen oder dem Internet, verbunden.

Dennoch erfordern Anwendungsfälle, wie beispielsweise ein zentrales Zustandsüberwachungssystem oder Fehleranalysen, dass Daten von Systemen aus einem abgeschlossenen Netz an ein offenes Netz übertragen werden können. Oft erfolgt ein Datentransfer dabei strikt unidirektional, d.h. Daten können lediglich aus dem abgeschlossenen Netz in ein anderes Netz übertragen werden. Ein Informationsfluss in nur eine Richtung kann beispielsweise mittels einer Datendiode erreicht werden, wobei dabei der Datentransfer in der Regel nicht robust gegenüber Datenverlusten auf der Kommunikationsstrecke ist.

Die Datenübertragung über unidirektionale Netzwerkstrecken erfolgt typischerweise mittels User Datagram Protocol, kurz UDP, welches keine Fehlerkorrektur auf Protokollschicht bietet, d.h. eine

Empfangskomponente kann einer Senderkomponente keine Rückmeldung über den Zustand eines empfangenen Netzwerkpakets übermitteln. Für die Absicherung und Korrektur einer Datentransferstrecke
wird häufig ein Vorwärts-Fehlerkorrektur-Verfahren (Forward Error Correction, FEC) eingesetzt, das gezielt Redundanzen einbaut, um z.B. einen unvollständigen Datentransfer auszugleichen. Dadurch werden allerdings Transfervolumen vergrößert und bekannte Vorwärts-Fehlerkorrektur-Verfahren erfordern in der Regel, dass bis zur Dekodierung die erhaltenen kodierten Daten im Hauptspeicher eines Empfangsgeräts gehalten werden können. Dies stellt insbesondere für Geräte mit beschränkter Rechen- und Hauptspeicherkapazität, auch als (Resource) Constrained Devices bezeichnet, ein Problem dar.

US 2018/109356 A1 offenbart das Übertragen eines Datensatzes mit Vorwärts-Fehlerkorrektur zwischen einem Hochsicherheitsnetzwerk und einem externen Netzwerk über ein unidirektionales Sende- und Empfangssystem.

Es ist daher eine Aufgabe der vorliegenden Erfindung, einen unidirektionalen Datentransfer, der mit einem Vorwärts-Fehlerkorrektur-Verfahren abgesichert ist, zu einem Gerät mit beschränkter Rechen- und Hauptspeicherkapazität zu ermöglichen.

Die Aufgabe wird gelöst durch ein Verfahren mit den Merkmalen des Patentanspruchs 1, ein System, ein Computerprogrammprodukt und einen Datenträger. Vorteilhafte Ausführungsformen und Weiterbildungen der Erfindung sind in den abhängigen Ansprüchen angegeben.

Ein erster Aspekt der Erfindung betrifft ein Verfahren zum fehlerkorrigierenden Übertragen eines Datensatzes von einem ersten Netzwerk in ein zweites Netzwerk über eine unidirektionale Kommunikationseinheit mit den Verfahrensschritten:
- Unterteilen des Datensatzes in Teildatensätze im ersten Netzwerk, wobei ein Teildatensatz jeweils mindestens ein Zeichen umfasst,
- Kodieren der Teildatensätze durch Hinzufügen von mindestens einem Korrekturzeichen an jeden der Teildatensätze,
- Übertragen der Zeichen und Korrekturzeichen der kodierten Teildatensätze vom ersten Netzwerk an eine Empfangseinheit im zweiten Netzwerk über die unidirektionale Kommunikationseinheit,

- Empfangen der Zeichen und Korrekturzeichen der kodierten Teildatensätze im zweiten Netzwerk,
- Dekodieren der kodierten Teildatensätze, wobei
   a) Zeichen und Korrekturzeichen, die einem ersten kodierten Teildatensatz zugeordnet sind, in einem Hauptspeicher gespeichert werden,
   b) Zeichen und Korrekturzeichen, die anderen kodierten Teildatensätzen zugeordnet sind, in einem Hintergrundspeicher zwischengespeichert werden, und
   c) der erste kodierte Teildatensatz dekodiert wird und anschließend die bisher empfangenen Zeichen und/oder Korrekturzeichen eines der anderen kodierten Teildatensätze vom Hintergrundspeicher in den Hauptspeicher verschoben werden, wobei die Schritte a) bis c) iterativ für jeden der kodierten Teildatensätze des Datensatzes durchgeführt werden,
      und
- Wiederherstellen des Datensatzes aus den dekodierten Teildatensätzen im zweiten Netzwerk.

Unter Kodierung kann im Zusammenhang mit der Erfindung insbesondere Fehlerkodierung verstanden werden. Mittels einer Fehlerkodierung kann anhand von Korrekturzeichen, die jeweils mindestens einem der Zeichen eines Datensatzes zuzuordnen sind bzw. ein Korrekturzeichen einem der Zeichen eines Teildatensatzes zuzuordnen ist, bei einer unvollständigen Übertragung von Zeichen trotzdem eine Dekodierung durchgeführt werden. Ein Datensatz kann insbesondere in mindestens einen Teildatensatz unterteilt werden. Korrekturzeichen können auch als Redundanz bezeichnet werden. Eine Dekodierung eines Teildatensatzes kann insbesondere erfolgen, wenn eine Menge von Zeichen und/oder Korrekturzeichen empfangen wurde, die für eine Dekodierung ausreichend sind. Sobald alle Teildatensätze dekodiert vorliegen, kann der Datensatz im zweiten Netzwerk wiederhergestellt werden.

Unter einem ersten Netzwerk kann insbesondere ein sicherheitskritisches Netz, wie z.B. ein Industrienetzwerk, und unter einem zweiten Netzwerk kann insbesondere ein offenes Netzwerk verstanden werden. Insbesondere wird ein Datensatz, unterteilt in kodierte Teildatensätze, vom ersten Netzwerk über eine unidirektionale Kommunikationseinheit ins zweite Netzwerk übermittelt. Die unidirektionale Kommunikationseinheit gewährleistet die Rückwirkungsfreiheit.

Das erfindungsgemäße Verfahren kann insbesondere einen unidirektionalen Datentransfer, wobei Daten kodiert übermittelt werden, zu einem Gerät mit eingeschränkter Hauptspeicher- und Rechenkapazität, wie z.B. eine Komponente in einem Industrienetzwerk, ermöglichen. Ein Datensatz kann schrittweise als einzelne fehlerkodierte Teildatensätze in das zweite Netzwerk übermittelt und dort iterativ dekodiert werden. Ein erster kodierter Teildatensatz muss nicht notwendigerweise der erste Teil eines Datensatzes sein, sondern kann ein erster aus der Menge an Teildatensätzen eines Datensatzes sein. Es können zur Fehlerkorrektur beliebig viele Korrekturzeichen hinzugefügt werden. Insbesondere kann die Anzahl der Teildatensätze, in die ein Datensatz unterteilt wird, beliebig gewählt sein.

Es ist weiterhin ein Vorteil der Erfindung, dass lediglich Zeichen und/oder Korrekturzeichen eines der Teildatensätze im Hauptspeicher gehalten und dort dekodiert werden. Die Zeichen und/oder Korrekturzeichen der anderen Teildatensätze werden nach Empfang auf einem Hintergrundspeicher zwischengespeichert. So kann insbesondere schrittweise eine Dekodierung im Hauptspeicher, z.B. eines Empfangsgeräts mit beschränktem Speicherplatz, erfolgen. Sobald beispielsweise ein Teildatensatz im Hauptspeicher dekodierbar ist, kann ein Austausch der Zeichen und/oder Korrekturzeichen eines anderen Teildatensatzes aus dem Hintergrundspeicher in den Hauptspeicher erfolgen. Abhängig von der Speicher- und Rechenkapazität des Hauptspeichers ist es auch möglich, dass mehr als ein erster kodierter Teildatensatz im Hauptspeicher gespeichert und dekodiert werden kann.

In einer vorteilhaften Ausführungsform des Verfahrens können Zeichen und Korrekturzeichen der kodierten Teildatensätze jeweils einzeln und/oder in beliebiger Reihenfolge und/oder unabhängig von einer Zuordnung zu einem der kodierten Teildatensätze übermittelt werden.

Eine Übertragung eines Datensatzes über die unidirektionale Kommunikationseinheit kann insbesondere über UDP erfolgen und unabhängig von einer Reihenfolge oder Zuordnung. Dabei ist es vorteilhaft, dass die Dekodierung auf Empfängerseite unabhängig von der Übertragungsreihenfolge der Zeichen und/oder Korrekturzeichen oder Zuordnung zu einem Datensatz ist.

In einer vorteilhaften Ausführungsform des Verfahrens können Zeichen und/oder Korrekturzeichen, die einem zweiten kodierten Teildatensatz zugeordnet sind, vom Hintergrundspeicher in den Hauptspeicher verschoben werden, sobald
- für den im Hauptspeicher gespeicherten ersten kodierten Teildatensatz eine zum Dekodieren vollständige Menge an Zeichen und/oder Korrekturzeichen im Hauptspeicher vorliegt oder
- für den zweiten kodierten Teildatensatz eine größere Menge an Zeichen und/oder Korrekturzeichen vorliegt als für den ersten kodierten Teildatensatz, wobei die bisher empfangenen Zeichen und/oder Korrekturzeichen des ersten kodierten Teildatensatz in den Hintergrundspeicher verschoben werden.

Es ist vorteilhaft, das iterative Dekodieren der Teildatensätze abhängig von der Menge an empfangenen Zeichen und/oder Korrekturzeichen pro Teildatensatz durchzuführen. Somit wird insbesondere derjenige Teildatensatz im Hauptspeicher gespeichert und dann zuerst dekodiert, für den die größte Menge an Zeichen und/oder Korrekturzeichen vorliegt, d.h. bereits empfangen wurde. Die Auswahl, für welchen Teildatensatz empfangene Zeichen und/oder Korrekturzeichen im Hauptspeicher gespeichert werden kann insbesondere auch durch eine Wahrscheinlichkeitsberechnung, abhängig von der Reihenfolge und/oder Rate von Zeichen und/oder Korrekturzeichen eines Teildatensatzes, bestimmt werden. Sobald eine für eine Dekodierung notwendige Menge an Zeichen und/oder Korrekturzeichen für einen kodierten Teildatensatz vorliegt, kann dieser kodierte Teildatensatz dekodiert werden. Nachfolgend können Zeichen und/oder Korrekturzeichen eines anderen, zweiten kodierten Teildatensatzes vom Hintergrundspeicher in den Hauptspeicher verschoben werden. Alternativ kann eine Menge an Zeichen und/oder Korrekturzeichen eines kodierten Teildatensatzes vom Hintergrundspeicher in den Hauptspeicher verschoben werden, wenn beispielsweise davon mehr Zeichen und/oder Korrekturzeichen vorliegen und somit eine Dekodierung dieses Teildatensatzes schneller möglich ist als für den Teildatensatz im Hauptspeicher. Die Zeichen und/oder Korrekturzeichen der Teildatensätze können folglich vom Haupt- in den Hintergrundspeicher, und vice versa, verschoben werden. Damit kann ein effizientes Dekodieren und Speichermanagement erreicht werden, da die nicht zum Dekodieren benötigten Zeichen und/oder Korrekturzeichen eines Teildatensatzes nach Empfang in den Hintergrundspeicher verschoben werden können.

In einer vorteilhaften Ausführungsform des Verfahrens können die empfangenen Zeichen und/oder Korrekturzeichen im zweiten Netzwerk mittels einer Verwaltungseinheit verwaltet werden und damit bestimmt werden, welche Zeichen und/oder Korrekturzeichen zu einem kodierten Teildatensatzes im Hauptspeicher gespeichert werden.

Mittels einer Verwaltungseinheit, insbesondere einer Tabelle, können die auf einem Gerät im zweiten Netzwerk empfangenen Zeichen und/oder Korrekturzeichen verwaltet, d.h. insbesondere geordnet und einem Teildatensatz zugeordnet, werden. Die Verwaltungseinheit umfasst insbesondere Informationen über die Zeichen und/oder Korrekturzeichen, wie z.B. Empfangszeit, Reihenfolge und Zuordnung zu einem entsprechenden Teildatensatz.

In einer vorteilhaften Ausführungsform des Verfahrens kann mittels der Verwaltungseinheit derjenige kodierte Teildatensatz, für den die größte Menge an empfangene Zeichen und/oder Korrekturzeichen vorliegt, ermittelt werden und die empfangenen Zeichen und/oder Korrekturzeichen dieses kodierten Teildatensatz im Hauptspeicher abgelegt werden.

Anhand der in der Verwaltungseinheit, z.B. einer Tabelle, gespeicherten Information, wie z.B. der Anzahl an empfangenen Zeichen und/oder Korrekturzeichen eines kodierten Teildatensatzes, kann ermittelt werden, für welchen kodierten Teildatensatz eine vollständige oder fast vollständige Menge an Zeichen und/oder Korrekturzeichen zum Dekodieren vorliegt. Vorzugsweise werden Zeichen und/oder Korrekturzeichen dieses Teildatensatzes im Hauptspeicher gehalten. Beispielsweise kann in einer Tabelle ein Index die Anzahl an empfangenen Zeichen und/oder Korrekturzeichen zu einem im Hauptspeicher gehaltenen kodierten Teildatensatz angeben.

In einer vorteilhaften Ausführungsform des Verfahrens kann mittels der Verwaltungseinheit die Menge an empfangenen Zeichen und/oder Korrekturzeichen eines kodierten Teildatensatzes ermittelt und aus der ermittelten Menge die Vollständigkeit für eine Dekodierung eines kodierten Teildatensatzes bestimmt werden.

Anhand der in der Verwaltungseinheit gespeicherten Information kann insbesondere bestimmt werden, ob für einen kodierten Teildatensatz bereits eine ausreichende Menge an Zeichen und/oder Korrekturzeichen für eine Dekodierung im zweiten Netzwerk empfangen wurde.

In einer vorteilhaften Ausführungsform des Verfahrens kann eine Information der Verwaltungseinheit bei Empfang eines Zeichens und/oder Korrekturzeichens im zweiten Netzwerk aktualisiert werden.

Vorzugsweise wird auf der Empfangsseite die Verwaltungseinheit beim Empfang eines weiteren Zeichens und/oder Korrekturzeichens aktualisiert, wobei insbesondere eine Zuordnung zu einem Teildatensatz erfolgt. Beispielsweise kann ein Index einer Tabelle entsprechend inkrementiert werden.

In einer vorteilhaften Ausführungsform des Verfahrens erfolgt das Kodieren der Teildatensätze im ersten Netzwerk durch ein vorgegebenes Vorwärtsfehlerkorrektur-Verfahren.

In einer vorteilhaften Ausführungsform des Verfahrens erfolgt das Dekodieren der Teildatensätze im zweiten Netzwerk gemäß dem vorgegebenen Vorwärtsfehlerkorrektur-Verfahren.

Ein Vorwärtsfehlerkorrektur-Verfahren, auch als "Forward Error Correction", kurz FEC, bezeichnet, kann insbesondere eine Anzahl an Korrekturzeichen, wie z.B. Rekonstruktionsdaten, vorgeben. Verfahren für die Vorwärtsfehlerkorrektur sind u.a. die Trellis-Codierung und der Reed-Solomon-Code.

Ein weiterer Aspekt der Erfindung betrifft ein System zum fehlerkorrigierenden Übertragen eines Datensatzes von einem ersten Netzwerk in ein zweites Netzwerk über eine unidirektionale Kommunikationseinheit, umfassend:
- eine Unterteilungseinheit, die derart ausgebildet ist, den Datensatz im ersten Netzwerk in Teildatensätze zu unterteilen, wobei ein Teildatensatz jeweils mindestens ein Zeichen umfasst,
- eine Kodiereinheit im ersten Netzwerk, die derart ausgebildet ist die Teildatensätze durch Hinzufügen von mindestens einem Korrekturzeichen an jeden der Teildatensätze zu kodieren,
- eine unidirektionale Kommunikationseinheit, die derart ausgebildet ist, die Zeichen und Korrekturzeichen der kodierten Teildatensätze vom ersten Netzwerk an eine Empfangseinheit im zweiten Netzwerk zu übertragen,
- die Empfangseinheit im zweiten Netzwerk, die derart ausgebildet ist, die Zeichen und Korrekturzeichen der kodierten Teildatensätze zu empfangen, wobei die Empfangseinheit einen Hauptspeicher, einen Hintergrundspeicher und eine Dekodiereinheit zum Dekodieren der kodierten Teildatensätze umfasst, wobei
   a) Zeichen und Korrekturzeichen, die einem ersten kodierten Teildatensatz zugeordnet sind, im Hauptspeicher gespeichert werden,
   b) Zeichen und Korrekturzeichen, die anderen kodierten Teildatensätzen zugeordnet sind, im Hintergrundspeicher zwischengespeichert werden,
   c) der erste kodierte Teildatensatz dekodiert und anschließend die bisher empfangenen Zeichen und/oder Korrekturzeichen eines der anderen kodierten Teildatensätze vom Hintergrundspeicher in den Hauptspeicher verschoben werden,
      wobei die Schritte a) bis c) iterativ für jeden der kodierten Teildatensätze des Datensatzes durchgeführt werden,
   und
- eine Wiederherstellungseinheit, die derart ausgebildet ist, den Datensatz aus den dekodierten Teildatensätzen im zweiten Netzwerk wiederherzustellen.

Die Unterteilungseinheit zum Unterteilen eines Datensatzes in Teildatensätze und die Kodiereinheit sind insbesondere im ersten Netzwerk in einem Gerät integriert oder mit diesem gekoppelt. Die Dekodiereinheit, der Hauptspeicher, der Hintergrundspeicher und die Wiederherstellungseinheit können beispielsweise miteinander gekoppelt sein, wobei insbesondere die Dekodiereinheit, der Hauptspeicher, und der Hintergrundspeicher in der Empfangseinheit integriert sein können. Der Hauptspeicher und/oder der Hintergrundspeicher können auch als Teil der Dekodiereinheit ausgebildet sein. Die Empfangseinheit, die Dekodiereinheit, der Hauptspeicher, der Hintergrundspeicher und die Wiederherstellungseinheit können insbesondere Teil eines Geräts im zweiten Netzwerk sein, wobei dieses lediglich eine beschränkte Rechen- und Hauptspeicherkapazität aufweist.

In einer vorteilhaften Ausführungsform umfasst das System eine Verwaltungseinheit zum Verwalten der empfangenen Zeichen und/oder Korrekturzeichen im zweiten Netzwerk.

Die Verwaltungseinheit kann insbesondere als eine Tabelle in der Empfangseinheit oder dem Hauptspeicher ausgebildet und mit der Dekodiereinheit gekoppelt oder in dieser gespeichert sein.

Des Weiteren betrifft die Erfindung ein Computerprogrammprodukt, das direkt in einen programmierbaren Computer ladbar ist, umfassend Programmcodeteile, die dazu geeignet sind, die Schritte eines erfindungsgemäßen Verfahrens durchzuführen, und einen Datenträger, der das Computerprogrammprodukt speichert.

Ausführungsbeispiele des erfindungsgemäßen Verfahrens und System sind in den Zeichnungen beispielhaft dargestellt und werden anhand der nachfolgenden Beschreibung näher erläutert. Es zeigen:
- Fig. 1: ein Ablaufdiagramm eines erfindungsgemäßen Verfahrens;
- Fig. 2: eine schematische Darstellung eines erfindungsgemäßen Verfahrens; und
- Fig. 3: eine schematische Darstellung eines erfindungsgemäßen Systems.

Einander entsprechende Gegenstände sind in allen Figuren mit den gleichen Bezugszeichen versehen.

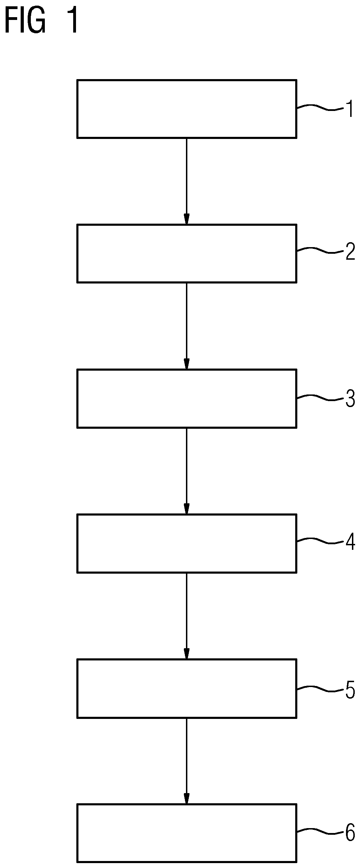

Figur 1 zeigt in schematischer Darstellung die Schritte eines erfindungsgemäßen Verfahrens zum fehlerkorrigierenden Übertragen eines Datensatzes von einem ersten Netzwerk in ein zweites Netzwerk über eine unidirektionale Kommunikationseinheit. Der Datentransfer nach dem erfindungsgemäßen Verfahren ist insbesondere rückwirkungsfrei, d.h. eine Datenübertragung erfolgt lediglich unidirektional aus dem ersten Netzwerk in das zweite Netzwerk. Auf Empfangsseite kann insbesondere ein Gerät mit eingeschränktem Hauptspeicher, wie z.B. ein Feldgerät, eingesetzt werden.

In Schritt 1 wird ein Datensatz auf einem Gerät im ersten Netzwerk, wie z.B. einem sicherheitskritischen Netz einer Industrieanlage, erfasst und in Teildatensätze unterteilt. Beispielsweise handelt es sich um Messdaten, welche zur Diagnose in ein zweites Netzwerk, wie z.B. ein Diagnosenetzwerk, übermittelt werden sollen. Aufgrund von Sicherheitsvorgaben erfolgt der Datentransfer vom ersten Netzwerk in das zweite Netzwerk über eine unidirektionale und somit rückwirkungsfreie Kommunikationseinheit. Zum Senden eines Datensatzes wird der Datensatz in einzelne Teildatensätze unterteilt und mittels UDP übertragen. Ein Teildatensatz umfasst dabei mindestens ein Zeichen des Datensatzes.

In Schritt 2 werden die Teildatensätze kodiert, insbesondere fehlerkodiert. Dazu wird jedem Teildatensatz mindestens ein Korrekturzeichen hinzugefügt, wobei ein Korrekturzeichen insbesondere gleich einem Zeichen des entsprechenden Teildatensatzes ist und/oder mittels Wahrscheinlichkeitsberechnungen ermittelt werden kann. Es wird folglich Redundanz gemäß einem vorgegebenen Vorwärtsfehlerkorrektur-Verfahren eingebaut. Dies ermöglicht beispielsweise bei Datenverlusten während der Übertragung, dass auf Empfangsseite eine vollständige Wiederherstellung des übertragenen Datensatzes möglich ist. Eine Rückkopplung von Empfängerkomponente zu Sendekomponente ist somit nicht notwendig.

In Schritt 3 werden die kodierten Teildatensätze über die unidirektionale Kommunikationseinheit übertragen, d.h. von einer Sendeeinheit eines Geräts im ersten Netzwerk an eine Empfangseinheit im zweiten Netzwerk übermittelt. Die Übermittlung erfolgt insbesondere mittels User Datagram Protocol, kurz UDP. Die Zeichen und/oder Korrekturzeichen der einzelnen Teildatensätze werden dabei in einzelnen Datenpaketen und in beliebiger Reihenfolge über die unidirektionale Kommunikationseinheit übermittelt.

In Schritt 4 werden die Zeichen und/oder Korrekturzeichen von einer Empfangseinheit im zweiten Netzwerk empfangen. Dort liegen sie beispielsweise in ungeordneter Reihenfolge vor. Mittels einer Verwaltungseinheit, insbesondere einer Tabelle, kann die Empfangszeit, die Reihenfolge der empfangenen Zeichen und/oder Korrekturzeichen und deren Zuordnung zu einem der Teildatensätzen verwaltet werden. Anhand der Tabelle kann insbesondere ein erster Teildatensatz ermittelt werden, für den Zeichen und/oder Korrekturzeichen im Hauptspeicher der Empfangseinheit gespeichert werden. Zeichen und/oder Korrekturzeichen anderer Teildatensätze können mittels der Tabelle verwaltet werden und werden in den Hintergrundspeicher zwischengespeichert.

In Schritt 5 werden die empfangenen, kodierten Teildatensätze dekodiert. Dazu muss eine ausreichende Anzahl an Zeichen und/oder Korrekturzeichen eines Teildatensatzes vorliegen. Insbesondere muss nicht notwendigerweise eine vollständige Menge an Zeichen eines Teildatensatzes vorliegen, wenn beispielsweise für eine Dekodierung genügend Korrekturzeichen empfangen wurden. Die empfangenen Zeichen und/oder Korrekturzeichen werden zunächst abhängig von ihrer Zuordnung zu einem Teildatensatz entweder auf dem Hauptspeicher oder auf dem Hintergrundspeicher gespeichert. Beispielsweise werden Zeichen und/oder Korrekturzeichen eines ersten Teildatensatzes im Hauptspeicher gespeichert und Zeichen und/oder Korrekturzeichen der anderen Teildatensätze im Hintergrundspeicher. Sobald der erste kodierte Teildatensatz vollständig zum Dekodieren im Hauptspeicher vorliegt, wird er dekodiert. Anschließend werden Zeichen und/oder Korrekturzeichen einer der anderen kodierten Teildatensätze vom Hintergrundspeicher in den Hauptspeicher verschoben. Das Vorgehen wird solange iterativ durchgeführt bis alle Teildatensätze dekodiert in der Empfangseinheit vorliegen, so dass, im Schritt 6, daraus der transferierte Datensatz wiederhergestellt werden kann. Der Datensatz kann anschließend im zweiten Netzwerk weiterverarbeitet oder genutzt werden.

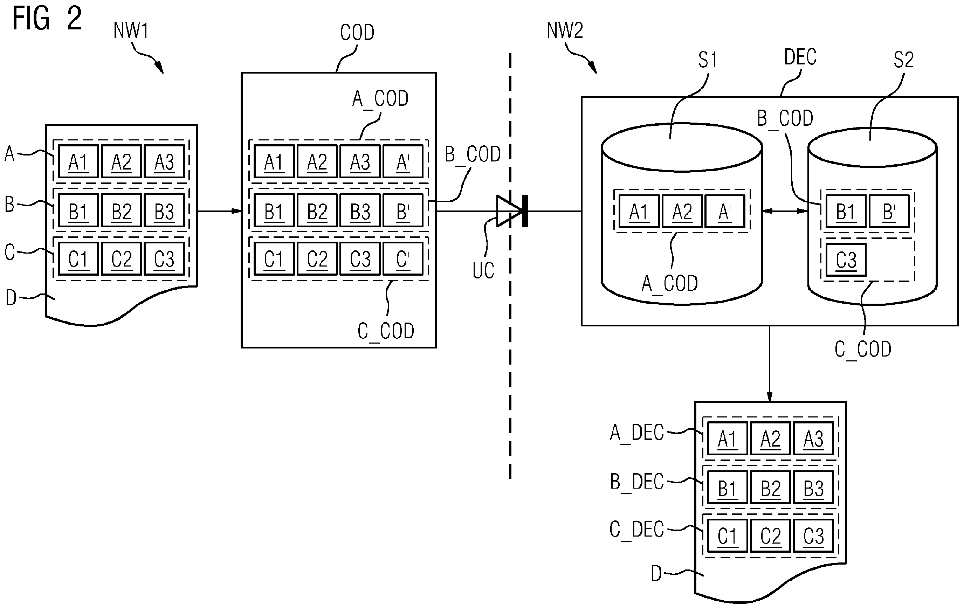

Figur 2 zeigt schematisch den Ablauf eines erfindungsgemäßen Verfahrens. Es sind das erste Netzwerk NW1 und das zweite Netzwerk NW2 gezeigt, welche durch eine unidirektionale Kommunikationseinheit UC verbunden sind, d.h. es kann lediglich ein Datentransfer vom ersten Netzwerk NW1 in das zweite Netzwerk NW2 erfolgen. Die Datenübertragung eine Datensatzes D erfolgt erfindungsgemäß mittels Fehlerkodierung des Datensatzes D, so dass mögliche Datenverluste bei der Übertragung, ausgeglichen werden können.

Im ersten Netzwerk NW1 wird ein Datensatz D für die Übermittlung in das zweite Netzwerk NW2 in Teildatensätze A, B, C unterteilt, die jeweils aus Zeichen A1,A2,A3,...,C3 bestehen. Die Anzahl der Teildatensätze und Zeichen, wobei hier beispielhaft drei Teildatensätze A, B, C gezeigt sind, kann beliebig gewählt sein bzw. variiert, d.h. muss insbesondere nicht gleich drei sein, und ist abhängig vom vorgegebenen Vorwärts-fehlerkorrektur-Verfahren, der Transferrate und/oder Datenpaketgröße. Die Teildatensätze werden in einer Kodiereinheit COD kodiert. Dazu wird jedem Teildatensatz mindestens ein Korrekturzeichen A', B', C' hinzugefügt. Somit umfasst der kodierte Datensatz die kodierten Teildatensätze A_COD, B_COD, C_COD. Die Anzahl der kodierten Teildatensätze ist abhängig von der Anzahl der Teildatensätze und ist hier nur beispielhaft mit drei angegeben.

Die kodierten Teildatensätze A_COD, B_COD, C_COD werden über die unidirektionale Kommunikationseinheit UC ins zweite Netzwerk NW2 übertragen. Die Übertragung erfolgt per UDP, dabei werden die Zeichen und/oder Korrekturzeichen abhängig von einer Größe eines Netzwerkpakets als Datenpakete transferiert. Die Übertragung der Zeichen und/oder Korrekturzeichen erfolgt unabhängig von ihrer Reihenfolge und/oder Zuordnung zu einem Teildatensatz. Insbesondere erfolgt die Übertragung in der Regel nicht pro Teildatensatz, so dass die Zeichen und/oder Korrekturzeichen auf Empfängerseite ungeordnet vorliegen können.

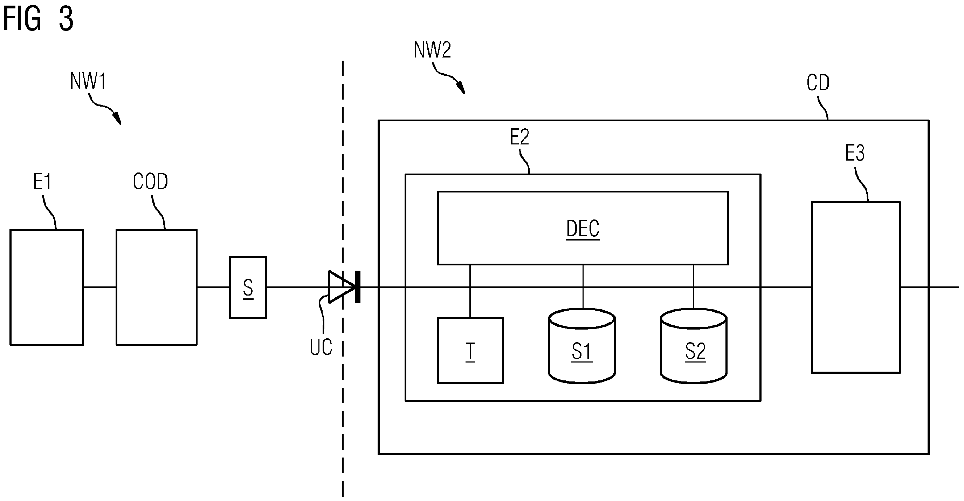

Erfindungsgemäß werden die Zeichen und/oder Korrekturzeichen auf einem Hauptspeicher S1 oder auf einem Hintergrundspeicher S2, die jeweils Teil der Dekodiereinheit DEC sein können, gespeichert. Der Hauptspeicher S1 und der Hintergrundspeicher S2 können auch mit der Dekodiereinheit gekoppelt oder in diese integriert ausgestaltet sein, wie beispielhaft in Figur 3 gezeigt. Es werden beispielsweise Zeichen und/oder Korrekturzeichen A1, A2, A' eines ersten Teildatensatzes A_COD im Hauptspeicher gespeichert. Es wird insbesondere ein erster kodierter Teildatensatz A_COD bestimmt, für den die größte Menge an empfangenen Zeichen und/oder Korrekturzeichen vorliegt und für den weitere, empfangene Zeichen und/oder Korrekturzeichen im Hauptspeicher gespeichert werden. Die empfangenen Zeichen und/oder kodierter Korrekturzeichen B1, B', C3 anderer kodierter Teildatensätze B_COD, C_COD werden währenddessen im Hintergrundspeicher zwischengespeichert.

Für eine Dekodierung im zweiten Netzwerk NW2 müssen ausreichend Zeichen und/oder Korrekturzeichen eines Teildatensatzes A_COD, B_COD, C_COD, gemäß dem vorgegebenen Fehlerkorrektur-verfahren, vorliegen. Es kann ein Austausch von Zeichen und/oder Korrekturzeichen zwischen dem Hauptspeicher S1 und dem Hintergrundspeicher S2 erfolgen, sobald der erste Teildatensatz A_COD dekodiert werden kann oder sobald für einen anderen Teildatensatz B_COD, C_COD mehr Zeichen und/oder Korrekturzeichen im Hintergrundspeicher vorliegen. Die Verwaltung der empfangenen Zeichen und/oder Korrekturzeichen kann mittels einer Verwaltungseinheit, wie z.B. einer Tabelle, erfolgen. Anhand der Tabelle kann effizient ermittelt werden, wann ein Austausch von Zeichen und/oder Korrekturzeichen zwischen dem Haupt- und dem Hintergrundspeicher S1, S2 erfolgen kann.

Sobald alle kodierten Teildatenätze A_COD, B_COD, C_COD vollständig zur Dekodierung vorliegen, werden sie dekodiert und der Datensatz D kann aus diesen dekodierten Teildatensätzen A_DEC, B_DEC, C_DEC wiederhergestellt werden.

Figur 3 zeigt beispielhaft ein erfindungsgemäßes System zum fehlerkorrigierenden Übertragen eines Datensatzes von einem ersten Netzwerk in ein zweites Netzwerk über eine unidirektionale Kommunikationseinheit.

Das erste Netzwerk NW1 kann beispielsweise ein sicherheitskritisches Industrienetzwerk und das zweite Netzwerk NW2 kann beispielsweise ein offenes Büronetzwerk sein. Die Netzwerke NW1 und NW2 sind miteinander lediglich über eine Einweg-Kommunikationseinheit UC verbunden.

Das System umfasst im ersten Netzwerk NW1 eine Unterteilungseinheit E1 zum Unterteilen des Datensatzes in Teildatensätze und eine Kodiereinheit COD, zum Kodieren der Teildatensätze durch Hinzufügen von mindestens einem Korrekturzeichen an jeden der Teildatensätze. Des Weiteren kann das System eine Sendeeinheit S im ersten Netzwerk NW1 umfassen, welche beispielsweise mit der Unterteilungseinheit E1 und/oder Kodiereinheit COD gekoppelt oder in diese integriert ist, und einen Datensatz an eine Empfangseinheit E2 im zweiten Netzwerk NW2 sendet. Beispielsweise sind die Sendeeinheit S, die Unterteilungseinheit E1 und die Kodiereinheit COD Teil eines Geräts im ersten Netzwerk NW1.

Das System umfasst eine unidirektionale Kommunikationseinheit UC zum rückwirkungsfreien Übertragen der kodierten Teildatensätze vom ersten Netzwerk NW1 in das zweite Netzwerk NW2. Auf Empfängerseite im zweiten Netzwerk NW2 umfasst das System eine Empfangseinheit E2 und eine Wiederherstellungseinheit E3. Die Empfangseinheit E2 und die Wiederherstellungseinheit E3 können insbesondere Teil eines Geräts CD sein. Die Empfangseinheit E2 umfasst insbesondere eine Dekodiereinheit DEC zum Dekodieren der empfangenen, kodierten Teildatensätze, einen Hauptspeicher S1, einen Hintergrundspeicher S2 und eine Tabelle T. Der Hauptspeicher S1 kann insbesondere eine beschränkte Speicher- und Rechenkapazität aufweisen. Die Dekodiereinheit DEC, der Hauptspeicher S1, der Hintergrundspeicher S2 und die Verwaltungseinheit T können vorzugsweise miteinander gekoppelt sein. Insbesondere kann die Verwaltungseinheit T auch Teil des Hauptspeichers S1 sein (nicht dargestellt). Die Verwaltungseinheit T kann als Tabelle verstanden werden. Anhand der Verwaltungseinheit T wird insbesondere die Speicherung und der Austausch von Zeichen und/oder Korrekturzeichen zwischen Haupt- und Hintergrundspeicher S1, S2 verwaltet. Die Wiederherstellungseinheit E3 stellt den transferierten Datensatz wieder aus den dekodierten Teildatensätzen her und stellt diesen Datensatz für eine weitere Bearbeitung im zweiten Netzwerk NW bereit.

Die Einheiten des Systems können jeweils insbesondere mindestens einen Prozessor umfassen, der die Funktionen ausführt. Das System kann des Weiteren einen Prozessor umfassen, auf dem ein erfindungsgemäßes Computerprogrammprodukt, umfassend Programmcodeteile, laufen kann, um die Schritte eines erfindungsgemäßen Verfahrens rechnergestützt durchzuführen.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt und wird durch die angehängten Patentansprüche definiert.

## Patentansprüche

1. Verfahren zum fehlerkorrigierenden Übertragen eines Datensatzes (D) von einem ersten Netzwerk (NW1) in ein zweites Netzwerk (NW2) über eine unidirektionale Kommunikationseinheit (UC) mit den Verfahrensschritten:
- Unterteilen (1) des Datensatzes in Teildatensätze (A, B, C) im ersten Netzwerk (NW1), wobei ein Teildatensatz (A, B, C) jeweils mindestens ein Zeichen (A1, A2, ..., C3) umfasst,
- Kodieren (2) der Teildatensätze (A, B, C) durch Hinzufügen von mindestens einem Korrekturzeichen (A', B', C') an jeden der Teildatensätze,
- Übertragen (3) der Zeichen und Korrekturzeichen (A1, A2, ..., C3, A', B', C') der kodierten Teildatensätze (A_COD, B_COD, C_COD) vom ersten Netzwerk (NW1) an eine Empfangseinheit im zweiten Netzwerk (NW2) über die unidirektionale Kommunikationseinheit (UC),
- Empfangen (4) der Zeichen und Korrekturzeichen (A1, A2, ..., C3, A', B', C') der kodierten Teildatensätze (A_COD, B_COD, C_COD) im zweiten Netzwerk (NW2),
- Dekodieren (5) der kodierten Teildatensätze, wobei
a) Zeichen und Korrekturzeichen, die einem ersten kodierten Teildatensatz (A1, A2, A') zugeordnet sind, in einem Hauptspeicher (S1) gespeichert werden,
b) Zeichen und Korrekturzeichen, die anderen kodierten Teildatensätzen (B1, B', ...) zugeordnet sind, in einem Hintergrundspeicher (S2) zwischengespeichert werden, und
c) der erste kodierte Teildatensatz (A1, A2, A') dekodiert wird und anschließend die bisher empfangenen Zeichen und/oder Korrekturzeichen eines der anderen kodierten Teildatensätze (B_COD, C_COD) vom Hintergrundspeicher (S2) in den Hauptspeicher (S1) verschoben werden,
wobei die Schritte a) bis c) iterativ für jeden der kodierten Teildatensätze (A_COD, B_COD, C_COD) des Datensatzes (D) durchgeführt werden,
und
- Wiederherstellen (6) des Datensatzes (D) aus den dekodierten Teildatensätzen (A_DEC, B_DEC, C_DEC) im zweiten Netzwerk (NW2) .

2. Verfahren nach Anspruch 1, wobei Zeichen und Korrekturzeichen der kodierten Teildatensätze (A_COD, B_COD, C_COD) jeweils einzeln und/oder in beliebiger Reihenfolge und/oder unabhängig von einer Zuordnung zu einem der kodierten Teildatensätze (A_COD, B_COD, C_COD) übermittelt werden.

3. Verfahren nach einem der vorhergehenden Ansprüche, wobei Zeichen und/oder Korrekturzeichen, die einem zweiten kodierten Teildatensatz (B COD) zugeordnet sind, vom Hintergrundspeicher (S2) in den Hauptspeicher (S1) verschoben werden, sobald für den im Hauptspeicher (S1) gespeicherten ersten kodierten Teildatensatz (A_COD) eine zum Dekodieren vollständige Menge an Zeichen und/oder Korrekturzeichen im Hauptspeicher (S1) vorliegt.

4. Verfahren nach Anspruch 1 oder 2, wobei Zeichen und/oder Korrekturzeichen, die einem zweiten kodierten Teildatensatz (B_COD) zugeordnet sind, vom Hintergrundspeicher (S2) in den Hauptspeicher (S1) verschoben werden, sobald für den zweiten kodierten Teildatensatz (B_COD) eine größere Menge an Zeichen und/oder Korrekturzeichen vorliegt als für den ersten kodierten Teildatensatz (A_COD), wobei die bisher empfangenen Zeichen und/oder Korrekturzeichen des ersten kodierten Teildatensatz (A_COD) in den Hintergrundspeicher (S2) verschoben werden.

5. Verfahren nach einem der vorhergehenden Ansprüche, wobei die empfangenen Zeichen und/oder Korrekturzeichen im zweiten Netzwerk (NW2) mittels einer Verwaltungseinheit (T) verwaltet werden und damit bestimmt wird, welche Zeichen und/oder Korrekturzeichen zu einem kodierten Teildatensatzes (A_COD, B_COD, C_COD) im Hauptspeicher (S1) gespeichert werden.

6. Verfahren nach Anspruch 5, wobei mittels der Verwaltungseinheit (T) derjenige kodierte Teildatensatz, für den die größte Menge an empfangene Zeichen und/oder Korrekturzeichen vorliegt, ermittelt wird und die Zeichen und/oder Korrekturzeichen dieses kodierten Teildatensatz im Hauptspeicher (S1) gespeichert werden.

7. Verfahren nach einem der Ansprüche 5 oder 6, wobei mittels der Verwaltungseinheit (T) die Menge an empfangenen Zeichen und/oder Korrekturzeichen eines kodierten Teildatensatzes ermittelt und aus der ermittelten Menge die Vollständigkeit für eine Dekodierung eines kodierten Teildatensatzes bestimmt wird.

8. Verfahren nach einem der Ansprüche 5 bis 7, wobei eine Information der Verwaltungseinheit (T) bei Empfang eines Zeichens und/oder Korrekturzeichens im zweiten Netzwerk (NW2) aktualisiert wird.

9. Verfahren nach einem der vorhergehenden Ansprüche, wobei das Kodieren der Teildatensätze (A, B, C) im ersten Netzwerk (NW1) durch ein vorgegebenes Vorwärtsfehlerkorrektur-Verfahren erfolgt.

10. Verfahren nach Anspruch 9, wobei das Dekodieren der Teildatensätze im zweiten Netzwerk (NW2) gemäß dem vorgegebenen Vorwärtsfehlerkorrektur-Verfahren erfolgt.

11. System zum fehlerkorrigierenden Übertragen eines Datensatzes von einem ersten Netzwerk (NW1) in ein zweites Netzwerk (NW2) über eine unidirektionale Kommunikationseinheit (UC), umfassend:
- eine Unterteilungseinheit (E1), die derart ausgebildet ist, den Datensatz im ersten Netzwerk (NW1) in Teildatensätze zu unterteilen, wobei ein Teildatensatz jeweils mindestens ein Zeichen umfasst,
- eine Kodiereinheit (COD) im ersten Netzwerk (NW1), die derart ausgebildet ist, die Teildatensätze durch Hinzufügen von mindestens einem Korrekturzeichen an jeden der Teildatensätze zu kodieren,
- eine unidirektionale Kommunikationseinheit (UC), die derart ausgebildet ist, die Zeichen und Korrekturzeichen der kodierten Teildatensätze vom ersten Netzwerk (NW1) an eine Empfangseinheit im zweiten Netzwerk (NW2) zu übertragen,
- die Empfangseinheit (E2) im zweiten Netzwerk (NW2), die derart ausgebildet ist, die Zeichen und Korrekturzeichen der kodierten Teildatensätze zu empfangen, wobei die Empfangseinheit (E2) einen Hauptspeicher (S1), einen Hintergrundspeicher (S2) und eine Dekodiereinheit (DEC) zum Dekodieren der kodierten Teildatensätze umfasst, wobei
a) Zeichen und Korrekturzeichen, die einem ersten kodierten Teildatensatz zugeordnet sind, im Hauptspeicher (S1) gespeichert werden,
b) Zeichen und Korrekturzeichen, die anderen kodierten Teildatensätzen zugeordnet sind, im Hintergrundspeicher (S2) zwischengespeichert werden, und
c) der erste kodierte Teildatensatz (A1, A2, A') dekodiert wird und anschließend die bisher empfangenen Zeichen und/oder Korrekturzeichen eines der anderen kodierten Teildatensätze (B_COD, C_COD) vom Hintergrundspeicher (S2) in den Hauptspeicher (S1) verschoben werden,
wobei die Schritte a) bis c) iterativ für jeden der kodierten Teildatensätze (A_COD, B_COD, C_COD) des Datensatzes (D) durchgeführt werden,
und
- eine Wiederherstellungseinheit (E3), die derart ausgebildet ist, den Datensatz aus den dekodierten Teildatensätzen im zweiten Netzwerk (NW2) wiederherzustellen.

12. System nach Anspruch 11, umfassend eine Verwaltungseinheit (T) zum Verwalten der empfangenen Zeichen und/oder Korrekturzeichen im zweiten Netzwerk (NW2).

13. Computerprogrammprodukt, das direkt in einen programmierbaren Computer ladbar ist, umfassend Programmcodeteile, die bei der Ausführung des Programms durch den Computer diesen veranlassen, die Schritte eines Verfahrens nach einem der Ansprüche 1 bis 10 durchzuführen.

14. Datenträger, der das Computerprogrammprodukt nach Anspruch 13 speichert.

## Claims

1. Method for the error-correcting transmission of a data record (D) from a first network (NW1) to a second network (NW2) via a unidirectional communication unit (UC), having the method steps of:
- dividing (1) the data record into data subrecords (A, B, C) in the first network (NW1), wherein a data subrecord (A, B, C) comprises at least one respective character (A1, A2, ..., C3),
- coding (2) the data subrecords (A, B, C) by adding at least one correction character (A', B', C') to each of the data subrecords,
- transmitting (3) the characters and correction characters (A1, A2, ..., C3, A', B', C') of the coded data subrecords (A_COD, B_COD, C_COD) from the first network (NW1) to a receiving unit in the second network (NW2) via the unidirectional communication unit (UC),
- receiving (4) the characters and correction characters (A1, A2, ..., C3, A', B', C') of the coded data subrecords (A_COD, B_COD, C_COD) in the second network (NW2),
- decoding (5) the coded data subrecords, wherein
a) characters and correction characters assigned to a first coded data subrecord (A1, A2, A') are stored in a main memory (S1),
b) characters and correction characters assigned to other coded data subrecords (B1, B', ...) are buffer-stored in a background memory (S2), and
c) the first coded data subrecord (A1, A2, A') is decoded and subsequently the previously received characters and/or correction characters of one of the other coded data subrecords (B_COD, C_COD) are moved from the background memory (S2) to the main memory (S1),
wherein steps a) to c) are performed iteratively for each of the coded data subrecords (A_COD, B_COD, C_COD) of the data record (D),
and
- restoring (6) the data record (D) from the decoded data subrecords (A_DEC, B_DEC, C_DEC) in the second network (NW2).

2. Method according to Claim 1, wherein characters and correction characters of the coded data subrecords (A_COD, B_COD, C_COD) are conveyed in each case individually and/or in any order and/or independently of an assignment to one of the coded data subrecords (A_COD, B_COD, C_COD).

3. Method according to either of the preceding claims, wherein characters and/or correction characters assigned to a second coded data subrecord (B_COD) are moved from the background memory (S2) to the main memory (S1) as soon as a complete quantity of characters and/or correction characters for decoding is available in the main memory (S1) for the first coded data subrecord (A_COD) stored in the main memory (S1) .

4. Method according to Claim 1 or 2, wherein characters and/or correction characters assigned to a second coded data subrecord (B_COD) are moved from the background memory (S2) to the main memory (S1) as soon as a larger quantity of characters and/or correction characters is available for the second coded data subrecord (B_COD) than for the first coded data subrecord (A_COD), wherein the previously received characters and/or correction characters of the first coded data subrecord (A_COD) are moved to the background memory (S2) .

5. Method according to one of the preceding claims, wherein the received characters and/or correction characters in the second network (NW2) are managed by means of a management unit (T) and this determines which characters and/or correction characters are stored for a coded data subrecord (A_COD, B_COD, C_COD) in the main memory (S1).

6. Method according to Claim 5, wherein the management unit (T) is used to ascertain that coded data subrecord for which the largest quantity of received characters and/or correction characters is available, and the characters and/or correction characters of this coded data subrecord are stored in the main memory (S1).

7. Method according to either of Claims 5 and 6, wherein the management unit (T) is used to ascertain the quantity of received characters and/or correction characters of a coded data subrecord and to determine from the ascertained quantity the completeness for a decoding of a coded data subrecord.

8. Method according to one of Claims 5 to 7, wherein information of the management unit (T) is updated when a character and/or correction character is received in the second network (NW2).

9. Method according to one of the preceding claims, wherein the coding of the data subrecords (A, B, C) in the first network (NW1) is effected by means of a stipulated forward error correction method.

10. Method according to Claim 9, wherein the decoding of the data subrecords in the second network (NW2) is effected according to the stipulated forward error correction method.

11. System for the error-correcting transmission of a data record from a first network (NW1) to a second network (NW2) via a unidirectional communication unit (UC), comprising:
- a dividing unit (E1) designed to divide the data record in the first network (NW1) into data subrecords, wherein a data subrecord comprises at least one respective character,
- a coding unit (COD) in the first network (NW1), designed to code the data subrecords by adding at least one correction character to each of the data subrecords,
- a unidirectional communication unit (UC) designed to transmit the characters and correction characters of the coded data subrecords from the first network (NW1) to a receiving unit in the second network (NW2),
- the receiving unit (E2) in the second network (NW2), designed to receive the characters and correction characters of the coded data subrecords, wherein the receiving unit (E2) comprises a main memory (S1), a background memory (S2) and a decoding unit (DEC) for decoding the coded data subrecords, wherein
a) characters and correction characters assigned to a first coded data subrecord are stored in the main memory (S1),
b) characters and correction characters assigned to other coded data subrecords are buffer-stored in the background memory (S2), and
c) the first coded data subrecord (A1, A2, A') is decoded and subsequently the previously received characters and/or correction characters of one of the other coded data subrecords (B_COD, C_COD) are moved from the background memory (S2) to the main memory (S1),
wherein steps a) to c) are performed iteratively for each of the coded data subrecords (A_COD, B_COD, C_COD) of the data record (D),
and
- a restoring unit (E3) designed to restore the data record from the decoded data subrecords in the second network (NW2).

12. System according to Claim 11, comprising a management unit (T) for managing the received characters and/or correction characters in the second network (NW2).

13. Computer program product loadable directly into a programmable computer, comprising program code parts that, when the program is executed by the computer, cause said computer to perform the steps of a method according to one of Claims 1 to 10.

14. Data carrier that stores the computer program product according to Claim 13.

## Revendications

1. Procédé de transmission avec correction d'erreurs d'un ensemble (D) de données d'un premier réseau (NW1) à un deuxième réseau (NW2) par une unité (UC) de communication unidirectionnelle, comprenant les stades de procédé :
- subdivision (1) de l'ensemble de données en des ensembles (A, B, C) de données partiels dans le premier réseau (NW1), dans lequel un ensemble (A, B, C) de données partiel comprend respectivement au moins un caractère (A1, A2, ..., C3),
- codage (2) des ensembles (A, B, C) de données partiels par ajout d'au moins un caractère (A', B', C') de correction à chacun des ensembles de données partiels,
- transmission (3) des caractères et des caractères (A1, A2, ..., C3, A', B', C') de correction des ensembles (A_COD, B_COD, C_COD) de données partiels codés du premier réseau (NW1) à une unité de réception dans le deuxième réseau (NW2) par l'unité (UC) de communication unidirectionnelle,
- réception (4) des caractères et des caractères (A1, A2, ..., C3, A', B', C') de correction des ensembles (A_COD, B_COD, C_COD) de données partiels codés dans le deuxième réseau (NW2),
- décodage (5) des ensembles de données partiels codés, dans lequel
a) on met en mémoire dans une mémoire (S1) principale des caractères et des caractères de correction, qui sont associés à un premier ensemble (A1, A2, A') de données partiel codé,
b) on met en mémoire tampon dans une mémoire (S2) secondaire des caractères et des caractères de correction, qui sont associés à d'autres ensembles (B1, B', ...) de données partiels codés,
c) on décode le premier ensemble (A1, A2, A') de données partiel codé et ensuite on fait passer de la mémoire (S2) secondaire à la mémoire (S1) principale les caractères et/ou les caractères de correction, reçus jusqu'ici, de l'un des autres ensembles (B_COD, C_COD) de données partiels codés,
dans lequel on effectue les stades a) à c) en itération pour chacun des ensembles (A_COD, B_COD, C_COD) de données partiels codés de l'ensemble (D) de données,
et
- on remet (6) l'ensemble (D) de données composé des ensembles (A_DEC, B_ DEC, C_ DEC) de données partiels décodés dans le deuxième réseau (NW2).

2. Procédé suivant la revendication 1, dans lequel on transmet des caractères et/ou des caractères de correction des ensembles (A_COD, B_COD, C_COD) de données partiels codés respectivement individuellement et/ou dans n'importe quel ordre et/ou indépendamment d'une association à l'un des ensembles (A_COD, B_COD, C_COD) de données partiels codés.

3. Procédé suivant l'une des revendications précédentes, dans lequel on fait passer de la mémoire (S2) secondaire à la mémoire (S1) principale des caractères et/ou des caractères de correction, qui sont associés à un deuxième ensemble (B_COD) de données partiel codé, dès qu'il y a, pour le premier ensemble (A_COD) de données partiel codé mis en mémoire dans la mémoire (S1) principale, une quantité complète pour le décodage de caractères et/ou de caractères de correction dans la mémoire (S1) principale.

4. Procédé suivant la revendication 1 ou 2, dans lequel on fait passer de la mémoire (S2) secondaire à la mémoire (S1) principale des caractères et/ou des caractères de correction, qui sont associés à un deuxième ensemble (B_COD) de données partiel codé, dès qu'il y a, pour le deuxième ensemble (B_COD) de données partiel codé, une quantité de caractères et/ou de caractères de correction plus grande que pour le premier ensemble (A_COD) de données partiel codé, dans lequel on fait passer, dans la mémoire (S2) secondaire, les caractères et/ou les caractères de correction reçus jusqu'ici du premier ensemble (A_COD) de données partiel codé.

5. Procédé suivant l'une des revendications précédentes, dans lequel on gère les caractères et/ou les caractères de correction reçus dans le deuxième réseau (NW2) au moyen d'une unité (T) de gestion et on détermine ainsi les caractères et/ou les caractères de correction d'un ensemble (A_COD, B_COD, C_COD) de données partiel codé, qui sont mis en mémoire dans la mémoire (S1) principale.

6. Procédé suivant la revendication 5, dans lequel au moyen de l'unité (T) de gestion, on détermine l'ensemble de données partiel codé, pour lequel il y a la quantité la plus grande de caractères et/ou de caractères de correction reçus et on met les caractères et/ou les caractères de correction de cet ensemble de données partiel codé en mémoire dans la mémoire (S1) principale.

7. Procédé suivant l'une des revendications 5 ou 6, dans lequel au moyen de l'unité (T) de gestion, on détermine la quantité de caractères et/ou de caractères de correction reçus d'un ensemble de données partiel codé et, à partir de la quantité déterminée, on détermine l'état complet pour un décodage d'un ensemble de données partiel codé.

8. Procédé suivant l'une des revendications 5 à 7, dans lequel on met à jour une information de l'unité (T) de gestion à la réception d'un caractère et/ou d'un caractère de correction dans le deuxième réseau (NW2).

9. Procédé suivant l'une des revendications précédentes, dans lequel le codage des ensembles (A, B, C) de données partiels dans le premier réseau (NW1) s'effectue par un procédé donné à l'avance de correction d'erreur par l'amont.

10. Procédé suivant la revendication 9, dans lequel le décodage des ensembles de données partiels dans le deuxième réseau (NW2) s'effectue suivant le procédé donné à l'avance de correction d'erreur par l'amont.

11. Système de transmission avec correction d'erreurs d'un ensemble de données d'un premier réseau (NW1) à un deuxième réseau (NW2) par une unité (UC) de communication unidirectionnelle comprenant :
- une unité (E1) de subdivision, qui est constituée de manière à subdiviser l'ensemble de données dans le premier réseau (NW1) en des ensembles de données partiels, un ensemble de données partiel comprenant respectivement au moins un caractère,
- une unité (COD) de codage dans le premier réseau (NW1), qui est constituée de manière à coder les ensembles de données partiels par ajout d'au moins un caractère de correction à chacun des ensembles de données partiels,
- une unité (UC) de communication unidirectionnelle, qui est constituée pour transmettre les caractères et caractères de correction des ensembles de données partiels codés du premier réseau (NW1) à une unité de réception du deuxième réseau (NW2),
- l'unité (E2) de réception du deuxième réseau (NW2), qui est constituée pour recevoir les caractères et caractères de correction des ensembles de données partiels codés, dans lequel l'unité (E2) de réception comprend une mémoire (S1) principale, une mémoire (S2) secondaire et une unité (DEC) de décodage pour le décodage des ensembles de données partiels codés, dans lequel
a) on met en mémoire dans une mémoire (S1) principale des caractères et des caractères de correction, qui sont associés à un premier ensemble de données partiel codé,
b) on met en mémoire tampon dans une mémoire (S2) secondaire des caractères et des caractères de correction, qui sont associés à d'autres ensembles de données partiels codés, et
c) on décode le premier ensemble (A1, A2, A') de données partiel codé et ensuite on fait passer de la mémoire (S2) secondaire à la mémoire (S1) principale les caractères et/ou les caractères de correction, reçus jusqu'ici, de l'un des autres ensembles (B_COD, C_COD) de données partiels codés,
dans lequel on effectue les stades a) à c) en itération pour chacun des ensembles (A_COD, B_COD, C_COD) de données partiels codés de l'ensemble (D) de données,
et
- une unité (E3) de rétablissement, qui est constituée pour remettre l'ensemble de données composé des ensembles de données partiels décodés dans le deuxième réseau (NW2).

12. Système suivant la revendication 11, comprenant une unité (T) de gestion pour la gestion des caractères et/ou de caractères de correction reçus dans le deuxième réseau (NW2).

13. Produit de programme d'ordinateur, qui peut être chargé directement dans un ordinateur programmable, comprenant des parties de code de programme, qui, lors de la réalisation du programme par l'ordinateur, font qu'elles effectuent les stades d'un procédé suivant l'une des revendications 1 à 10.

14. Support de données, qui met en mémoire le produit de programme d'ordinateur suivant la revendication 13.
